# EUROPÄISCHE PATENTSCHRIFT

(11) **EP 0 520 133 B1**
(45) Veröffentlichungstag und Bekanntmachung des Hinweises auf die Patenterteilung: **28.06.1995**
(21) Anmeldenummer: 92100972.6
(22) Anmeldetag: 22.01.1992
(51) Int. Cl.: C23C 14/56, C23C 14/26, C23C 14/24

(54) **Vorrichtung zur kontinuierlichen Beschichtung von bandförmigen Substraten**
Apparatus for continuous coating of strip substrates
Dispositif pour le revêtement en continu des substrats en bande

(30) Priorität: 25.06.1991 DE 4120910
(43) Veröffentlichungstag der Anmeldung: 30.12.1992
(73) Patentinhaber: LEYBOLD AKTIENGESELLSCHAFT, D-63450 Hanau (DE)
(72) Erfinder: Grimm, Helmut, Dr., W-6100 Darmstadt 12 (DE); Rübsam, Klemens, W-6485 Jossgrund 2 (DE)

(56) Entgegenhaltungen:
- DE-A- 3 615 487
- DE-C- 970 246
- PATENT ABSTRACTS OF JAPAN vol. 13, no. 536 (C-660)29. November 1989

## Beschreibung

Die Erfindung betrifft eine Vorrichtung zur kontinuierlichen Beschichtung bandförmiger Substrate in einer Vakuumbeschichtungskammer, mit einer Vielzahl von - eine Verdampferbank bildenden - Verdampferschiffchen gleicher Größe und Konfiguration, wobei jedes Verdampferschiffchen mit einer Kavität versehen ist, alle Verdampferschiffchen aus einer elektrisch leitenden Keramik gebildet, durch direkten Stromdurchgang beheizbar, längs zur Bandlaufrichtung und parallel nebeneinander in einer Linie angeordnet sind, welche sich quer zur Bandlaufrichtung erstreckt. Eine solche Vorrichtung ist aus Patent DE 40 27 034 bekannt.

Zum Stand der Technik sind Vorrichtungen zur laufenden Beschichtung von bandförmigen Substraten in einer Vakuumbeschichtungskammer bekannt, bei denen die Verdampferschiffchen längs zur Bandlaufrichtung und parallel in etwa gleichen Abständen zueinander angeordnet sind.

Weiterhin ist eine Vorrichtung bekannt (DE-PS 970 246), die - um eine möglichst gleichmäßige Schichtstärke auf dem zu beschichtenden Substrat zu erreichen - den Verdampferschiffchen entsprechende Kammern in zwei oder mehr parallelen Reihen in derart versetzter Anordnung aufweist, so daß - von der Seite gesehen - sich die Kammern gegenseitig überdecken und keine Bedampfungslücke entsteht.

Darüberhinaus ist eine Vorrichtung zur kontinuierlichen Bedampfung von bandförmigen Substraten bekannt (FR-A 2 052 433), bei der als Verdampfer eine Vielzahl von Verdampferschiffchen vorgesehen sind, die senkrecht zur Bandlaufrichtung angeordnet sind und die kontinuierlich bewegt und mit Quellenmaterial ergänzt werden. Die Beheizung der Einzelschiffchen ist individuell regelbar. Ein Nachteil besteht unter anderem darin, daß diese Verdampferschiffchen nicht für die Verdampfung von in Drahtform zugeführten Metallen geeignet ist.

Schließlich ist eine Vorrichtung zur kontinuierlichen Bedampfung von bandförmigen Substraten bekannt (JP-A 01-219 157), bei der eine Vielzahl von Verdampferschiffchen mit gleichem Abstand zueinander und in Bandlaufrichtung angeordnet sind und die durch direkten Stromdurchgang beheizbar sind.

Diese vorstehend gekennzeichneten Vorrichtungen haben sämtlich den Nachteil, daß durch die Überlagerung der Verdampferkeulen der Einzelquellen eine ungleichmäßige Schichtverteilung auf dem zu beschichtenden Band entsteht. Im Idealfall ist dies eine wellenförmige Verteilung mit Maxima bzw. Minima über bzw. zwischen den Schiffchen. Die bestenfalls erreichbare Schichtgleichmäßigkeit wird bestimmt durch die Amplitude von Maxima und Minima. Die Amplitude selbst ist abhängig von der geometrischen Anordnung und der Emissions-Charakteristik (Ratenverteilung) der Einzelquellen sowie von der Wechselwirkung der Einzelqellen miteinander.

Die obengenannte Vorrichtung nach DE 970 246 könnte möglicherweise die Schichtverteilung verbessern, hat aber den Nachteil, daß sie keinesfalls eine Alternative für eine Hochratenbeschichtung mit einer üblichen Beschichtungsrate von größer 1 »m/sec bei einer Bandbeschichtungsbreite von maximal 3 m darstellt, da
1. keine kontinuierliche Drahtzufuhr möglich und
2. die notwendige Energiezufuhr zum Verdampfen des Drahtes als technisch äußerst problematisch zu beurteilen ist.

Der vorliegenden Anmeldung liegt nun die Aufgabe zugrunde, unter Beibehaltung aller Vorteile und Eigenschaften der Vorrichtung, die Halterung der Verdampferschiffchen noch weiter zu vereinfachen und die Verdampferschiffchen so auszubilden und anzuordnen, daß deren gegenseitige Wechselwirkung weiter reduziert und zusätzlich die Schichtgleichmäßigkeit erhöht wird.

Diese Aufgabe wird erfindungsgemäß dadurch gelöst, daß die Grundfläche eines Verdampferschiffchens ein Vielfaches der Grundfläche einer Kavität beträgt und die Kavitäten zweier benachbarter Verdampferschiffchen jeweils zueinander so versetzt sind, daß sie alle gemeinsam eine sich parallel der Linie erstreckende Zone überdecken, deren Breite zwischen Null und weniger als der halben Länge eines Verdampferschiffchens beträgt.

Vorzugsweise ist die Grundfläche eines Verdampferschiffchens doppelt so groß wie die Grundfläche einer Kapazität, wobei mit Vorteil die Abstände zwischen zwei benachbarten Verdampferschiffchen alle gleich groß bemessen sind.

Die Breite der Beschichtungszone in Bandlaufrichtung ist zweckmäßigerweise variabel ausgebildet, wobei ein Abstand zwischen der Querachse einer Kavität und der Linie der Verdampferbank vorgesehen ist.

In einer bevorzugten Ausführungsform entspricht die Breite der Beschichtungszone zweimal dem Abstand zwischen der Querachse und der Linie.

Durch die Versetzung der Kavitäten reduziert sich die Zahl der Stöße von Dampfatomen untereinander (die freie Weglange der Dampfatome liegt bei ca. 3 mm) und damit die gegenseitige Wechselwirkung. Dies wiederum bewirkt mit Vorteil eine nun flachere, wellenförmige Intensitätsverteilung mit Maxima bzw. Minima über bzw. zwischen den Schiffchen und somit eine bessere Gleichmäßigkeit der aufzudampfenden Schicht.

Die Erfindung läßt die verschiedensten Ausführungsmöglichkeiten zu; eine davon ist in der anliegenden Zeichnung näher dargestellt, und zwar zeigt:

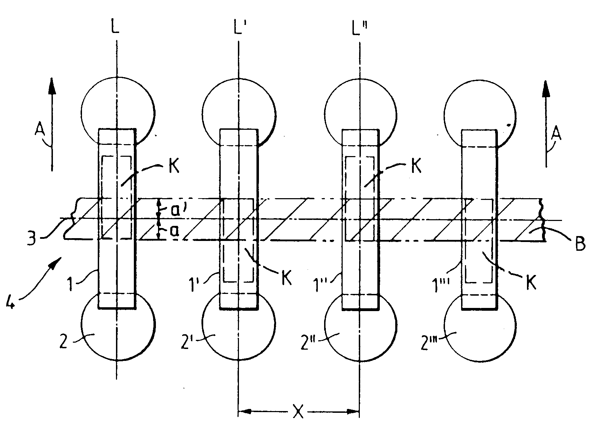

- Fig. 1: eine schematische Darstellung von Verdampferschiffchen für die Al-Bandbeschichtung als Einzelquellen in paralleler Anordnung mit erfindungsgemäß versetzten Kavitäten in der Draufsicht

Die rechteckförmigen Verdampferschiffchen 1, 1', ... weisen auf ihren Oberflächen ebenso rechteckige Vertiefungen auf, die nachfolgend als Kavität K, K', ... bezeichnet werden. An ihren Stirnseiten werden die Schiffchen 1, 1', ... von nahezu kreisrunden Einspannstücken 2, 2', ... gehalten und sind so angeordnet, daß ihre Längsachsen L, L', ... parallel und jeweils mit einem festen Abstand X zueinander verlaufen. Die Querachsen der einzelnen Verdampferschiffchen 1, 1', ... fallen mit der gemeinsamen Mittellinie 3 aller Schiffchen 1, 1', ... und somit der gesamten Verdampferbank 4 zusammen. Das zu beschichtende Band ist in Bandlaufrichtung A senkrecht zur Mittellinie 3 der Verdampferbank über diese hinweg bewegbar.

Die Kavitäten K, K', ... der Verdampferschiffchen 1, 1', ... sind mit ihren Querachsen jeweils um den Abstand a von der Mittellinie 3 der Verdampferbank wechselseitig versetzt, wobei jedoch alle Kavitäten K, K', ... gemeinsam eine schmale, schraffiert dargestellte Beschichtungszone B überdecken, die sich quer zur Bandlaufrichtung A erstreckt.

### Bezugszeichenliste

- 1, 1', ...: Verdampferschiffchen
- 2, 2', ...: Einspannstücke
- 3: Mittellinie Verdampferbank
- 4: Verdampferbank
- K, K', ...: Kavität
- L, L', ...: Längsachse Verdampferschiffchen
- X: Abstand Schiffchen zu Schiffchen
- A: Bandlaufrichtung
- B: Beschichtungszone
- a: Abstand Querachse Kavität zu Mittellinie Verdampferbank

## Patentansprüche

1. Vorrichtung zur kontinuierlichen Beschichtung bandförmiger Substrate in einer Vakuumbeschichtungskammer, mit einer Vielzahl von - eine Verdampferbank bildenden - Verdampferschiffchen (1, 1', ...) gleicher Größe und Konfiguration, wobei jedes Verdampferschiffchen (1, 1', ...) mit einer Kavität (K, K', ...) versehen ist, alle Verdampferschiffchen (1, 1', ...) aus einer elektrisch leitenden Keramik gebildet, durch direkten Stromdurchgang beheizbar, längs zur Bandlaufrichtung und parallel nebeneinander in einer Linie (3) angeordnet sind, welche sich quer zur Bandlaufrichtung (A) erstreckt, **dadurch gekennzeichnet**, daß die Grundfläche eines Verdampferschiffchens (1, 1', ...) ein Vielfaches der Grundfläche einer Kavität (K, K', ...) beträgt und die Kavitäten (K, K', ...) zweier benachbarter Verdampferschiffchen (1, 1', ...) jeweils zueinander so versetzt sind, daß sie alle gemeinsam eine sich parallel der Linie (3) erstreckende Zone (B) überdecken, deren Breite (a + a') zwischen Null und weniger als der halben Länge eines Verdampferschiffchen (1, 1', ...) beträgt.

2. Vorrichtung nach Anspruch 1, **dadurch gekennzeichnet**, daß die Grundfläche eines Verdampferschiffchens (1, 1', ...) doppelt so groß ist, wie die Grundfläche einer Kavität (K, K', ...).

3. Vorrichtung nach Anspruch 1, **dadurch gekennzeichnet**, daß die Abstände (X) zwischen zwei benachbarten Verdampferschiffchen (1, 1', ...) alle gleich groß sind.

4. Vorrichtung nach Anspruch 1, **dadurch gekennzeichnet**, daß die Breite der Beschichtungszone (B) in Bandlaufrichtung (A) variabel ist.

5. Vorrichtung nach Anspruch 1, **dadurch gekennzeichnet**, daß ein Abstand (a) zwischen der Querachse einer Kavität (K, K', ...) und der Mittellinie (3) der Verdampferbank (4) vorgesehen ist.

6. Vorrichtung nach den Ansprüchen 4 und 5, **dadurch gekennzeichnet**, daß die Breite der Beschichtungszone (B) zweimal der Abstand (a) ist.

## Claims

1. Apparatus for continuously coating strip substrates in a vacuum coating chamber, having a large number of evaporating boats (1, 1', ...) of the same size and configuration forming an evaporator bank, each evaporating boat (1, 1', ...) being provided with a cavity (K, K', ...), all evaporating boats (1, 1', ...) being formed from electrically conductive ceramic material, being heatable by directly passing through a current, and being disposed longitudinally to the direction of travel of the strip and parallel to one another in a line (3) extending transverse to the direction of travel (A) of the strip, characterised in that the base area of an evaporating boat (1, 1', ...) is a multiple of the base area of a cavity (K, K', ...), and the cavities (K, K', ...) of two adjacent evaporating boats (1, 1', ...) are staggered relative to one another so that all together they cover an area (B), which extends parallel to the line (3) and whose breadth (a + a') is between zero and less than half the length of an evaporating boat (1, 1', ...).

2. Apparatus according to claim 1, characterised in that the base area of an evaporating boat (1, 1', ...) is twice that of a cavity (K, K', ...).

3. Apparatus according to claim 1, characterised in that the gaps (X) between two adjacent evaporating boats (1, 1', ...) are all the same size.

4. Apparatus according to claim 1, characterised in that the breadth of the coating area (B) is variable in the direction of travel (A) of the strip.

5. Apparatus according to claim 1, characterised in that a distance (a) is provided between the transverse axis of a cavity (K, K', ...) and the centre line (3) of the evaporator bank (4).

6. Apparatus according to claims 4 and 5, characterised in that the breadth of the coating area (B) is twice the distance (a).

## Revendications

1. Dispositif pour le revêtement en continu de substrats en bande dans une chambre de revêtement sous vide, comportant une multitude de nacelles de vaporisation (1, 1', ...) de la même taille et de la même configuration, formant un banc de vaporisation, chaque nacelle de vaporisation (1, 1', ...) étant pourvue d'une cavité (K, K', ...), toutes les nacelles de vaporisation (1, 1', ...) étant formées en une céramique conductrice de l'électricité, qui peuvent être réchauffées par un passage de courant direct et qui sont agencées longitudinalement par rapport à la direction de circulation de bande et parallèlement les unes à côté des autres en une ligne (3) qui s'étend transversalement par rapport à la direction de circulation de bande (A), caractérisé en ce que la surface de base d'une nacelle de vaporisation (1, 1', ...) s'élève à un multiple de la surface de base d'une cavité (K, K', ...), et en ce que les cavités (K, K', ...) de deux nacelles de vaporisation voisines (1, 1', ...) sont respectivement décalées l'une par rapport à l'autre de telle sorte qu'elles recouvrent toutes conjointement une zone (B) s'étendant parallèlement à la ligne (3), dont la largeur (a + a') s'élève à une valeur entre zéro et moins de la demi-longueur d'une nacelle de vaporisation (1, 1', ...).

2. Dispositif selon la revendication 1, caractérisé en ce que la surface de base d'une nacelle de vaporisation (1, 1', ...) est double de la surface de base d'une cavité (K, K', ...).

3. Dispositif selon la revendication 1, caractérisé en ce que les distances (X) entre deux nacelles de vaporisation (1, 1', ...) voisines sont toutes égales les unes aux autres.

4. Dispositif selon la revendication 1, caractérisé en ce que la largeur de la zone de revêtement (B) est variable en direction de circulation de bande (A).

5. Dispositif selon la revendication 1, caractérisé en ce qu'il est prévu une distance (a) entre l'axe transversal d'une cavité (K, K', ...) et la ligne médiane (3) du banc de vaporisation (4).

6. Dispositif selon les revendications 4 et 5, caractérisé en ce que la largeur de la zone de revêtement (B) est le double de la distance (a).
